(19) **Europäisches Patentamt European Patent Office Office européen des brevets**

(11) **EP 2 325 945 A1**

(12) **EUROPEAN PATENT APPLICATION**
published in accordance with Art. 153(4) EPC

(43) Date of publication:
**25.05.2011 Bulletin 2011/21**

(51) Int Cl.:
***H01Q 17/00*** *(2006.01)*

(21) Application number: **09812720.2**

(22) Date of filing: **31.07.2009**

(86) International application number:
**PCT/ES2009/000412**

(87) International publication number:
**WO 2010/029193 (18.03.2010 Gazette 2010/11)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **12.09.2008 ES 200802609**

(71) Applicant: **Micromag 2000, S.L.**
**28003 Madrid (ES)**

(72) Inventors:
• **MARIN PALACIOS, Pilar**
**28224 Pozuelo de Alarcon Madrid (ES)**
• **CORTINA BLANCO, Daniel**
**Madrid (ES)**
• **GONZALEZ GORRITI, Ainoha**
**E-28003 Madrid (ES)**
• **HERNANDO GRANDE, Antonio**
**E-28023 Madrid (ES)**

(74) Representative: **Del Valle Valiente, Sonia**
**C/ Miguel Angel Cantero Oliva, 5,53**
**28660 Boadilla del Monte-Madrid (ES)**

(54) **ELECTROMAGNETIC-RADIATION ATTENUATOR AND METHOD FOR CONTROLLING THE SPECTRUM THEREOF**

(57)    The invention relates to an electromagnetic radiation attenuator and a method for controlling the spectrum thereof. The attenuator of the invention is formed from an attenuating sheet located such that, in the position of use of the attenuator, said electromagnetic radiation is incident on the attenuator sheet, and from a conductive base located, in the position of use of the attenuator, beneath said attenuator sheet. The attenuator sheet is formed by two layers, the first layer, made of dielectric material and of thickness $d_3$, being located directly on the metal sheet, and the second layer, of thickness $d_2$ formed by a dielectric material containing non-magnetic metal microwires with an insulating sheath of 1 to 2 mm in length, being located on the first layer and coating the whole, with the particularity that the second sheet is formed from a mixture of paint and microwires applied on the first sheet. Based on the impedances of the composite and of the dielectric, as well as the thickness of said composite, the spectrum of the attenuator can be controlled.

| Sample | $f_i$ (%) | l (mm) | d (μm) |
|--------|-----------|--------|--------|
| $L_1$  | 1.35      | 1      | 7      |
| $L_2$  | 0.55      | 2      | 7      |

TABLE 1

EP 2 325 945 A1

**Description**

Object of the Invention

The present invention relates to an attenuator for the electromagnetic radiation reflected by a metal based on metal microwires with an insulating sheath.

The invention is comprised within the technical field of metamaterials or composites, also covering aspects of electromagnetism, magnetic absorbers and metallurgy.

Background of the Invention

A number of applications require eliminating the reflections of electromagnetic radiation. The larger number of electronic systems incorporated in vehicles gives rise to an increase of electromagnetic interferences. This problem includes false images, interferences in radars and decrease in efficiency due to the coupling between some systems and others. A microwave absorber could be very effective to eliminate problems of this type. There is also a greater interest in reducing the radar section of determined systems to prevent or minimize the detection thereof.

Microwave absorbers are made by modifying the dielectric properties or, in other words, the dielectric permittivity, or magnetic permeability, of determined materials. In the first case, they are dielectric absorbers which base their operation on the principle of resonance at a quarter of the wavelength. However, in the second case. The magnetic component of the radiation is absorbed. The first attempts made to eliminate reflection include the method of the Salisbury absorbent screen, the non-resonant absorber, the resonant and the resonant magnetic ferrite absorbers. In the case of the Salisbury screen [patent US-2599944], a screen with a carefully chosen electric resistance is placed at the point where the electric field of the wave is maximum, i.e., at a distance equal to a quarter of the wavelength with respect to the surface which is to be screened. This method has little practical usefulness since the absorber is too thick and is only effective for a frequency band and a variation of incident angles that are too narrow.

In non-resonant methods, the radiation traverses a dielectric sheet to subsequently be reflected by the metal surface. The dielectric sheet is thick enough so that in the course of being reflected the wave is substantially attenuated before it re-emerges from the sheet. Because the sheet must be made of a material having small high-frequency losses and small reflection properties to assure penetration and reflection, the sheet must be very thick to effectively attenuate the wave.

In the first resonant methods, materials with high dielectric losses are directly placed on the conductive surface which is to be protected. The dielectric material has an effective thickness, measured inside the material, approximately equal to an even number of quarters of semi-wavelengths of the incident radiation. This method has limited usefulness due to the high thickness of the dielectric sheet and to the narrow absorption band that they have, especially at low frequencies. An attempt has been made to overcome these deficiencies by dispersing conductive ferromagnetic particles in the dielectric. However, when metal particles are dispersed in the dielectric, high permeabilities, in the order of 10 or 100, are not compatible with low conductivities, in the order of 10 or $10^{-8}$ mohm per meter.

Absorbers of another type are those known as ferrite absorbers [patent US-3938152], which have clear advantages over those already set forth herein. They work in the form of thin sheets such that they overcome the drawbacks of the high thickness required by dielectric absorbers. They are furthermore effective for frequencies between 10 MHz and 15,000 MHz and dissipate more energy than dielectrics.

Ferrite absorbers developed up until now eliminate reflections by means of insulating or semiconductor ferrite sheets, and particularly ferromagnetic metal oxides, placed directly on the reflective surface. In these cases, the term ferrite refers to ferromagnetic metal oxides including, but not limited to, compounds of the type of spinel, garnet, magnetoplumbite and perovskites.

In this type, the absorption is of two types, which may or may not occur simultaneously. They are dielectric and magnetic losses. The first losses are due to the transfer of electrons between the $Fe^{2+}$ and $Fe^{3+}$ cations whereas those of the second type originate from the movement and the relaxation of magnetic domain spins.

According to determined inventions [patent US-3938152], at low frequencies, generally those in the range between UHF and the L band, the energy is predominantly extracted from the magnetic component of the field of the incident radiation whereas at higher frequencies, generally in the L band and higher, the energy is equally extracted from the electric and magnetic component.

Absorbers of this type eliminate reflection because the radiation establishes a maximum magnetic field in the surface of the conductor. In a normal incidence of a plane wave on an ideal conductor, total reflection occurs, the reflected intensity is equal to the incident intensity. The incident and reflected waves are then formed generating a standing wave in which the electric field is nil at the boundary of the conductor, whereas the magnetic field at this boundary is maximum. There is a condensation of the magnetic field for the maximum possible time. Thus, in the case of ferrite, it is necessary for the incident radiation to traverse the absorbent sheet to establish the maximum magnetic field conditions. It has been seen that the complex part of the permeability of certain ferromagnetic metal oxides varies with the frequency such that it allows obtaining low reflections on very broad frequency ranges without needing to use magnetic absorbers of high thicknesses as in other cases.

Taking into account the reflection coefficient in metals for normal incidence it is deduced that when working with a thin sheet, the reflected wave can be attenuated independently of the electric permittivity of the absorbent material. There will be minimum reflections at a determined frequency if the complex permeability $\mu''$ is substantially greater than the real permeability $\mu'$ provided that the product $K\tau << 1$, where K is the wavenumber and $\tau$ is the thickness of the sheet.

Magnetic type absorbers can include those based on amorphous magnetic microwires obtained by Taylor's technique. This type of absorber can be both a paint and another type of dielectric matrix in which amorphous magnetic microwires with a high magnetic anisotropy which have ferromagnetic resonance properties can be randomly distributed. [patent US11/315645].

Taylor's technique for manufacturing microwires is known, which allows obtaining microwires with very small diameters comprised between one and several tens of microns through a simple process. The microwires thus obtained can be made from a large variety of magnetic and non-magnetic metals and alloys. This technique is described, for example, in the article "The Preparation, Properties and Applications of Some Glass Coated Metal Filaments Prepared by the Taylor-Wire Process" W. Donald et al., Journal of Material Science, 31, 1996, pp 1139-1148.

The most important characteristics of Taylor's method is that it allows obtaining metals and alloys in the form of a microwire with an insulating sheath in a single and simple operation with the cost-effectiveness that this implies in the manufacturing process.

The technique for obtaining of magnetic microwires with an insulating sleeve and amorphous microstructure is described, for example, in the article "Magnetic Properties of Amorphous Fe_P Alloys Containing Ga, Ge and As" H. Wiesner and J. Schneider, Stat. Sol. (a) 26, 71 (1974), Phys. Stat. Sol. (a) 26, 71 (1974).

In addition to amorphous magnetic microwires, Taylor's technique allows obtaining metal microwires of copper, silver and gold coated with pyrex. The diameters of the metal core of said microwire can be comprised between units and hundreds of a micron.

Absorbers of another type are those referred to in the patent US-4173018, which shows a mixture of balls of diameters between 0.5 and 20 microns in an insulating matrix where the mixture can be applied by painting or using a spray. The mixture is generally effective for attenuating electromagnetic radiation in the range between 2 and 10 GHz when a layer of approximately 0.04 inches is applied on the metal surface. The particles used are 90% of the weight of the mixture. Patents US-2918671 and US-2954552 show coatings for absorbing radiation at preselected wavelengths which are made up of dispersed graphite, aluminium, copper particles which are sufficiently insulated from one another in neutral matrixes such as waxes, resins and gums. Particles with an elongated shape and made of steel dispersed in a matrix are also described. Patent US-4034375 shows a laminated camouflage material including stainless steel or graphite conductive fibers on a plane essentially parallel to a first layer and a second layer containing non-woven flexible fibers with an electrically non-conductive material.

Patent US-4606848 relates to the composition of a paint for the absorption and the scattering of incident microwave radiation. Said paint contains uniformly distributed metal, carbon or stainless steel fibers. Said segments have lengths between 0.001 and 3 cm and diameters between $1\times10^{-6}$ and $3\times10^{-3}$ cm. The segments in question must be spaced an effective distance between half and double the wavelength object of attenuation and the size of which is half the wavelength of the incident radiation. This type of material fundamentally allows the absorption of waves with frequencies greater than 30 dB.

Of all the patents set forth herein, it can be considered that those having more advantages in relation to bandwidth and absorption levels, are the magnetic ones including those based on ferrites and those containing magnetic microwires. In the first type, there arises as a problem the high proportion of ferrite powder which, with respect to the mass of the dielectric support (paint, silicone) in which it is dissolved, is necessary, making these products have an excessively large weight. In the case of the product containing amorphous magnetic microwire, the absorption levels as well as the bandwidths are large enough to make this product be highly interesting from the point of view of the applications since, furthermore, the proportion of microwire necessary is much lower than in the case of ferrites. However, the control of the manufacturing process for amorphous materials is somewhat laborious.

In relation to the products prepared using metal fibers. it can be understood that the paint which is set forth in patent US4606848 is the one with the most advantages in relation to weight but it is not too feasible when radiations with frequencies within the range between 1 and 30 GHz are to be absorbed.

Description of the Invention

The electromagnetic radiation attenuator proposed by the invention fully and satisfactorily solves the problems set forth above, such that this attenuator is based on a metal surface which is coated with a sheet of dielectric material of thickness $d_3$ on which there is placed another sheet, of thickness $d_2$, of a composite of dielectric material in which copper microwires have been dispersed. Therefore, the radiation is incident on the sheet of composite, traversing it and subsequently passing through the dielectric in order to be finally reflected by the metal. The reflection coefficient, $R_0$, in the surface of the composite depends on is given by:

$$r_0 = \frac{r_{12} + r_{23}e^{-2j\gamma_2 d_2}}{1 + r_{12}r_{23}e^{-2j\gamma_2 d_2}}$$

Where $\gamma_i$ is the wave vector for the medium i and is given by

$$\gamma_i = \frac{\omega}{c}\sqrt{\varepsilon_i \mu_i}$$

$r_{12} = (Z_2 - Z_1)/(Z_2 + Z_1)$, $Z_1$ and $Z_2$ are the impedances of vacuum and of the composite, respectively and $r_{23}$ verifies

$$r_{23} = \frac{Z_3(1 - e^{-2j\gamma_3 d_3}) - Z_2(1 + e^{-2j\gamma_3 d_3})}{Z_3(1 - e^{-2j\gamma_3 d_3}) + Z_2(1 + e^{-2j\gamma_3 d_3})}$$

$Z_3$ is the impedance of the medium 3, such medium being the dielectric between the metal and the composite. It is important to emphasize that for loss-free media the impedances, $Z_1$, and $r_{12}$ are real, whereas $r_{23}$ is a complex number with modulus one, $r_{23} = e^{-j\xi}$ and $|R_o|$ is minimum for $\xi + 2\gamma_2\delta_2 = \pi$; with $\xi = -2\tan^{-1}(Z_3/Z_2\tan\gamma_3 d_3)$. This rule can be used as a guide to approximately determine the maximum absorption frequency as a function of the thicknesses $d_2$ and $d_3$ and the impedances $Z_2$ and $Z_3$.
The impedances are given by the following expressions:

$$Z_1 = \sqrt{\frac{\mu_0}{\varepsilon_0}}$$

Impedance of vacuum: it is a number close to 380Ω

Impedance of the dielectric: $Z_3 = \sqrt{\frac{\mu_0}{\varepsilon_3}}$ in these experiments it is virtually real since $\varepsilon_3 = \varepsilon_0(3.6 - 0.5j)$ and therefore $Z_3 = 0.58Z_1$

Impedance of the composite: $Z_2 = \sqrt{\frac{\mu_{comp}}{\varepsilon_{comp}}}$

It must be calculated, for the case of a very diluted dispersion of microwires in an insulating matrix, as indicated below.
In the case of having inclusions with a cylindrical geometry that are very diluted (the concentration, $p_i$, below the percolation threshold, with a determined volume fraction, $f_i$, and a known permittivity, $\varepsilon_i$) in a dielectric matrix of permittivity, $\varepsilon_h$, the generalized expression for the effective permittivity, $\varepsilon_{ef}$, of the composite is given by:

$$\varepsilon_{ef} = \varepsilon_h + \cfrac{\dfrac{1}{3} f_i (\varepsilon_i - \varepsilon_h) \sum \dfrac{\varepsilon_h}{\varepsilon_h + N_{i,j}(\varepsilon_i - \varepsilon_h)}}{1 - \dfrac{1}{3} f_i (\varepsilon_i - \varepsilon_h) \sum \dfrac{N_{i,j}}{\varepsilon_h + N_{i,j}(\varepsilon_i - \varepsilon_h)}}$$

For thin wires such as microwires for which the ration between the length, 1, and the diameter, d, is greater than 100, the depolarization factor $N_x = N_y = 1/2$ and $N_z = (d/l)^2 \ln(l/d)$. For metal microwires, $\varepsilon_i$ can be approximated to a pure imaginary number $\varepsilon_i = - (\sigma_i/\omega)j$

For frequencies of $10^{10}$ Hz and conductivity $\sigma_i$ comprised between $10^4$ and $10^6$ $(\Omega m)^{-1}$, $\varepsilon_i$ varies between $10^{-6}$ and $10^{-4}$, i.e., several orders of magnitude greater than $\varepsilon_h$, typically around $10^{-11}$.

For long metal microwires, the Maxwell Garnett expression is the following

$$\varepsilon_{ef} = \varepsilon_h + \frac{f_i \varepsilon_i \varepsilon_h}{\varepsilon_h + N_z \varepsilon_i}$$

Therefore, $N_z$ governs the behavior of the composite.

$$\varepsilon_{ef} = \varepsilon_h (1 + \frac{f_i}{N_z})$$

For $N_z \varepsilon_i \gg \varepsilon_h$

The effective permittivity is independent of that of the inclusions. However, for $N_z \varepsilon_i \ll \varepsilon_h$

$$\varepsilon_{ef} = \varepsilon_h + f_i \varepsilon_i$$

In this case, microwires of 1 or 2 mm in length and a diameter between 6 and 14 $\mu$m are used. Therefore, the minimum $N_z$ corresponds to 1=2mm and d= 6 $\mu$m, taking an approximate value of 5 $10^{-4}$, since $\varepsilon_i$ is, at 10 GHz, in the order of $10^{-3}$ or $10^{-5}$ Fm$^{-1}$ :

$N_z \varepsilon_i$ is always greater, at least orders of magnitude, than $\varepsilon_h$ and in this case (6.5-0.8j)x8.8 $10^{-12}$ Fm$^{-1}$

Therefore, in these experiments $\quad \varepsilon_{ef} = \varepsilon_h (1 + \frac{f_i}{N_z})$

In this case, since the details of $\varepsilon_i$ can be possible resonances, they do not affect the value of the impedance $Z_3$ or of the reflection coefficients $r_{23}$, $r_{12}$ and $r_0$, provided that $N_z \varepsilon_i$ remains much greater than $\varepsilon_h$.

Thus, according to the essential features of the invention, the attenuator, provide for a preselected frequency range, is formed by an attenuating sheet located such that, in the position of use of the attenuator, said electromagnetic radiation is incident on the attenuating sheet, and a preferably flat conductive base located, in the position of use of the attenuator, beneath said attenuating sheet, such that the mentioned attenuating sheet is formed by two layers, the first layer, made of dielectric material and of a determined thickness $d_3$, being located directly on the metal sheet, the second layer, of thickness $d_2$ formed by a dielectric material containing non-magnetic metal microwires with an insulating sheath of 1 to 2 mm in length, being located on the first layer and coating the whole.

The second sheet is produced by mixing the paint with the desirable amount of microwires and applying it with a spray on the first sheet

The frequencies object of screening are comprised between 0.5 and 40 GHz.

The frequency for which the attenuation is maximum, corresponds to the minimum value of the reflection coefficient in the surface of the composite.

The minimum valor of the reflection coefficient for a determined frequency is conditioned by the thicknesses $d_2$ and $d_3$ and the impedances $Z_2$ and $Z_3$ of the composite and of the dielectric respectively.

The impedance of the composite can be modified through the effective permittivity thereof.

The effective permittivity of the composite depends on the depolarization factor of the microwire.

The depolarization factor of the microwire depends on its length and diameter.

The attenuating sheet is preferably adhered to the conductive base and is adapted to its geometry.

The metal microwire used in the present invention is preferably a metal filament with a Pyrex® sheath in which the diameter is comprised between 6 and 14 μm.

Likewise, said microwires are preferably made of pure metals or of alloys.

The concentration of microwires is much lower than the percolation value.

The length of the microwires (1 or 2 mm) is less than the wavelength in the effective medium.

According to another of the features of the invention, each and every one of the attenuators has a characteristic spectrum associated therewith.

More specifically, a spectrum is the graphic depiction of the reflection coefficient as a function of the frequency of the incident radiation.

The characteristic parameters of the spectrum are the frequency associated with the minimum reflection peak, the attenuation level and the bandwidth.

The frequency associated with the maximum attenuation peak can be controlled based on the impedances of the dielectric and of the composite respectively, as well as based on their thicknesses.

The impedance of the composite can be controlled based on the geometry of the metal microwires.

The absorption bandwidth can be controlled using different proportions of microwires with different geometries.

The absorption bandwidth can also be controlled by varying the thickness $d_3$.

Description of the Drawings

To complement the description which is being made and for the purpose of aiding to better understand the features of the invention according to a preferred practical embodiment thereof, a set of drawings is attached as an integral part of said description, in which the following has been depicted with an illustrative and non-limiting character:

Figure 1 shows a diagram of the experimental device used.

Figure 2 shows a diagram of the attenuator with a flat geometry.

Figure 3a shows the losses due to reflection and the phase of the reflection coefficient ($R_0$) for four different thicknesses of methacrylate (M). The solid lines refer to the measurements and the dotted lines to the data of the model.

Figure 3b shows the losses due to reflection and the phase of the reflection coefficient ($R_0$) for a sheet of paint (P) with a thickness of 140 μm and four different thicknesses of methacrylate (M). The solid lines refer to the measurements and the dotted lines to the data of the model.

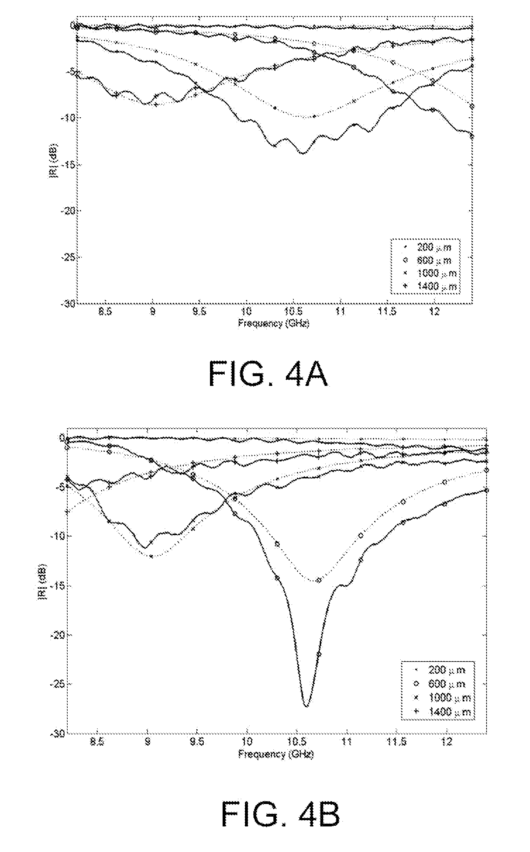

Figure 4a shows the return losses of the reflection coefficient ($R_0$) for the sample $L_1$ (1.35% of volume fraction of microwires of 1 mm in length) for four thicknesses of methacrylate (distance to the metal sheet). The solid lines refer to the measurements and the dotted lines to the data of the model. Figure 4b shows the return losses of the reflection coefficient ($R_0$) for the sample $L_2$ (0.55% of volume fraction of microwires of 2 mm in length) for four thicknesses of methacrylate (distance to the metal sheet). The solid lines refer to the measurements and the dotted lines to the data of the model.

Figure 5a shows the return losses of the reflection coefficient ($R_0$) for the sample $L_1$ (solid line), $L_1^1$ (dashed line) and $L_1^r$ (dashed line) for four thicknesses of methacrylate (distance to the metal sheet) (Table II) Figure 5b shows the return losses of the reflection coefficient ($R_0$) for the sample $L_2$ (solid line), $L_2^1$ (dashed line) and $L_2^r$ (dashed line) for four thicknesses of methacrylate (distance to the metal sheet) (Table II)

Table I shows the two types of composite prepared.

Table II shows the composites used in the model.

Preferred Embodiment of the Invention

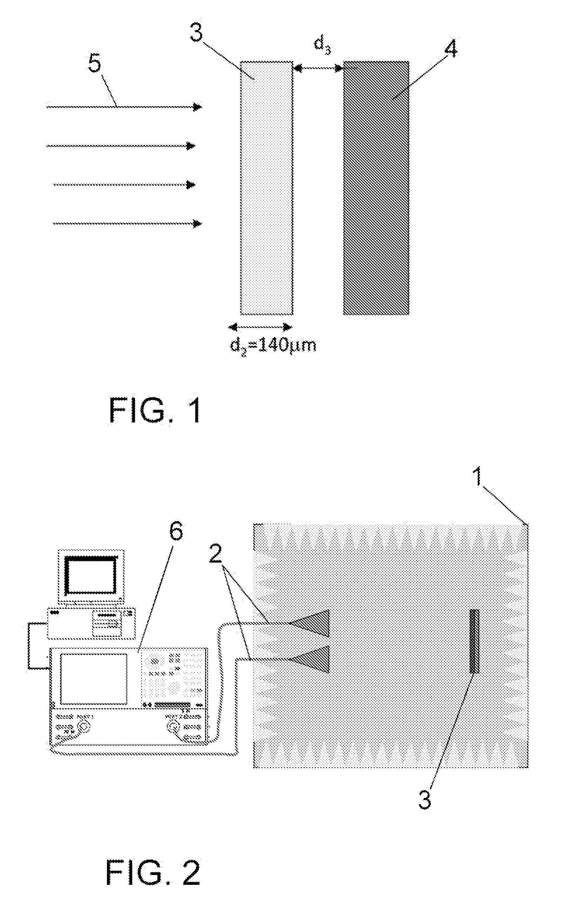

In view of the mentioned figures, and especially Figures 1 and 2, it can be observed how an anechoic chamber (1) with two antennas (2) (EMCO 3160-07) placed in far field (Frunahofer region) of the absorbent material (3) participates in the attenuator of the invention, and according to an experimental example. Its bandwidth ranges from 8.2 to 12.89 GHz. The attenuating material is placed on a metal sheet (4). The dimensions of the sheet are, in the chosen example, of 25 x 25 cm. Since the antenna (2) is located in far field, the waves (5) can be considered as plane waves, propagating in TEM mode. The antennas (2) are connected to a vector analyzer (6) (Agilent E8362B PNA Series Network Analyzer). The parameter $S_{12}$ is measured after a careful calibration. The real and imaginary parts of the reflection coefficient $R_0$ are also measured, R being represented in the spectra, which is defined based on the modulus of $R_0$ as

$$R=20\log(|R_0|) \ [dB].$$

The homogeneous dielectrics used are paint and methacrylate. Sheets of methacrylate with a thickness of 200 $\mu$m were cut to 25x25 cm to be adjusted to this experiment. These sheets were used to vary the distance between the attenuator (3) and the metal sheet (4). The paint is spread on the sheet of methacrylate and left to dry for 24 hours. The thickness of this layer is of 140 $\mu$m. The permittivities of these materials were measured by the reflection method.

The attenuating composite (3) is formed by the paint as a matrix in which copper microwires are placed as non-magnetic metal inclusions. These microwires are obtained by Taylor's rapid cooling technique and are cut to the desired length (1 or 2 mm). The composite is produced by mixing the paint with the desired amount of microwires and being spread by means of a spray on the metal sheet. The thickness of the composite is typically 140 $\mu$m. Table (I) shows the two types of samples prepared. Figure 2 shows a diagram of the attenuator object of characterization.

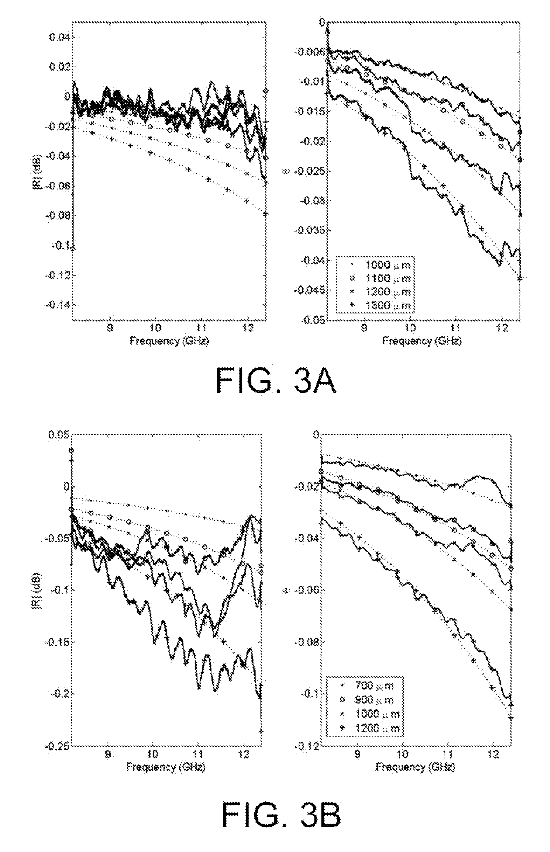

The permittivity of the paint (P) and of the methacrylate (M) is obtained from the parameter $S_{12}$. Said experimental parameter is adjusted with the Quasi-Newton algorithm. M type sheets with different thicknesses are placed on the metal surface and a 140 $\mu$m sheet of is placed thereon. The best fit is obtained for $\varepsilon_p$=6.5-j0.8 and $\varepsilon_M$ 3.6-j0.5. Figures 3-a and 3-b illustrate the losses due to reflection and the phase of $R_0$ for the paint and the methacrylate.

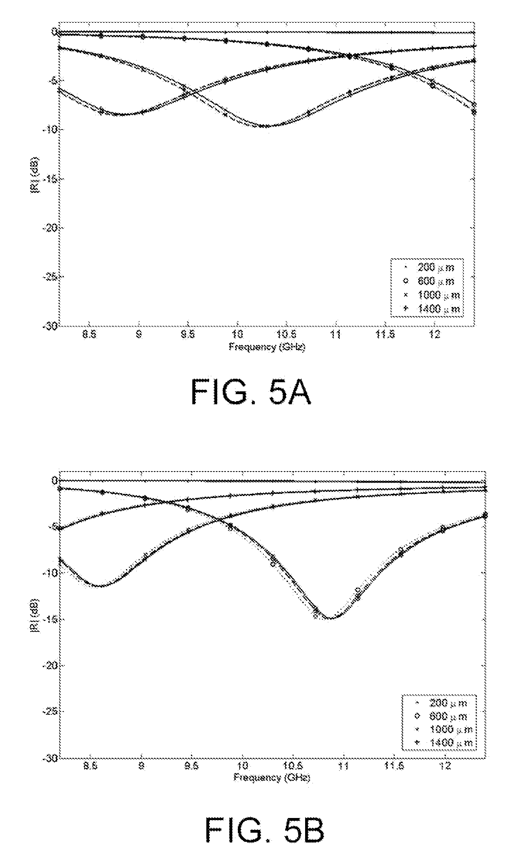

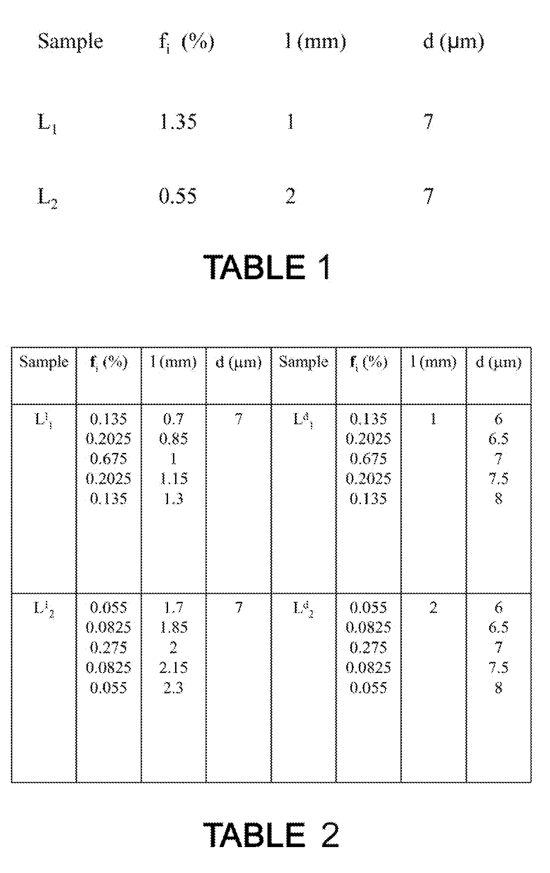

Figure 4 shows the coefficient $R_0$ for two composites made with microwires of a different length and different concentration. The two composites are studied for four different distances to the metal sheet. Figure 5 indicates the results obtained for the composites modeled in Table 2. This was done to assure that when a single type of microwire instead of a more realistic distribution of diameters and lengths is considered the error committed is negligible as shown in the figures.

The experimental results are drawn together with those calculated, almost perfect fits being obtained.

## Claims

1. An electromagnetic radiation attenuator, which, being of the type of those intended to attenuate the electromagnetic radiation reflected by a metal surface in a preselected frequency range, is **characterized in that** it is formed from an attenuating sheet located such that, in the position of use of the attenuator, said electromagnetic radiation is incident on the attenuating sheet, having a conductive base, which is not necessarily but preferably flat, located, in the position of use of the attenuator, beneath said attenuating sheet, it having been provided that the mentioned attenuating sheet is formed by two layers, the first layer, made of dielectric material and of a determined thickness $d_3$, being located directly on the metal sheet, and the second layer, of a determined thickness $d_2$ formed by a dielectric material containing non-magnetic metal microwires with an insulating sheath of 1 to 2 mm of length, being located on the first layer and coating the whole, with the particularity that the second sheet is formed from a mixture of paint and microwires applied on the first sheet.

2. The electromagnetic radiation attenuator according to claim 1, **characterized in that** the microwires are non-magnetic metal wires.

3. The electromagnetic radiation attenuator according to claim 1, **characterized in that** the amount of microwires inserted in the composite is below the percolation threshold.

4. The electromagnetic radiation attenuator according to claim 1, **characterized in that** the attenuating sheet is adhered to the conductive base.

5. A method for controlling the spectrum of the electromagnetic radiation attenuator of the previous claims, **characterized in that** the frequency associated with the maximum attenuation peak is controlled based on the impedances of the composite and of the dielectric.

6. The method according to claim 5, **characterized in that** the impedance of the composite is controlled based on the permittivity of the composite.

7. The method according to claim 6, **characterized in that** the size of the microwires is such that the product of the depolarization factor of the microwires, $N_z$, multiplied by the permittivity thereof, $\varepsilon_i$, is always greater than the permittivity of the dielectric, $\varepsilon_h$.

8. The method according to claims 6 and 7, **characterized in that** the permittivity of the composite is controlled based on the depolarization factor of the microwires.

9. The method according to claim 8, **characterized in that** the depolarization factor of the microwires is controlled based on its length.

10. The method according to claims 5 to 9, **characterized in that** the attenuation bandwidth is controlled based on the thickness of the composite.

**FIG. 1**

**FIG. 2**

FIG. 3A

FIG. 3B

FIG. 4A

FIG. 4B

FIG. 5A

FIG. 5B

| Sample | $f_i$ (%) | l (mm) | d (µm) |
|--------|-----------|--------|--------|
| $L_1$  | 1.35      | 1      | 7      |
| $L_2$  | 0.55      | 2      | 7      |

## TABLE 1

| Sample | $f_i$ (%) | l (mm) | d (µm) | Sample | $f_i$ (%) | l (mm) | d (µm) |
|--------|-----------|--------|--------|--------|-----------|--------|--------|
| $L^j_1$ | 0.135<br>0.2025<br>0.675<br>0.2025<br>0.135 | 0.7<br>0.85<br>1<br>1.15<br>1.3 | 7 | $L^d_1$ | 0.135<br>0.2025<br>0.675<br>0.2025<br>0.135 | 1 | 6<br>6.5<br>7<br>7.5<br>8 |
| $L^j_2$ | 0.055<br>0.0825<br>0.275<br>0.0825<br>0.055 | 1.7<br>1.85<br>2<br>2.15<br>2.3 | 7 | $L^d_2$ | 0.055<br>0.0825<br>0.275<br>0.0825<br>0.055 | 2 | 6<br>6.5<br>7<br>7.5<br>8 |

## TABLE 2

## INTERNATIONAL SEARCH REPORT

| | International application No. |
|---|---|
| | PCT/ ES 2009/000412 |

### A. CLASSIFICATION OF SUBJECT MATTER

*H01Q 17/00* (2006.01)

According to International Patent Classification (IPC) or to both national classification and IPC

### B. FIELDS SEARCHED

Minimum documentation searched (classification system followed by classification symbols)

H01Q17/00, H01B1/16, H01B1/22, H01B3/18

Documentation searched other than minimum documentation to the extent that such documents are included in the fields searched

Electronic data base consulted during the international search (name of data base and, where practicable, search terms used)

INVENES, EPODOC, WPI, NPL, XPESP, XPAIP, XPI3E, INSPEC.

### C. DOCUMENTS CONSIDERED TO BE RELEVANT

| Category* | Citation of document, with indication, where appropriate, of the relevant passages | Relevant to claim No. |
|---|---|---|
| A | EP 1675217 A1 (MICROMAG 2000, S.L.) 28.06.2006, the whole document. | 1-10 |
| A | US 2004104835 A1 (OJIMA) 03.06.2004, the whole document. | 1-10 |
| A | US 4606848 A (BOND) 19.08.1986, the whole document. | 1-10 |
| A | US 5085931 A (BOYER, III et al.) 04.02.1992, the whole document. | 1-10 |

☐ Further documents are listed in the continuation of Box C.    ☒ See patent family annex.

| | |
|---|---|
| *   Special categories of cited documents: <br> "A"   document defining the general state of the art which is not considered to be of particular relevance. <br> "E"   earlier document but published on or after the international filing date <br> "L"   document which may throw doubts on priority claim(s) or which is cited to establish the publication date of another citation or other special reason (as specified) <br> "O"   document referring to an oral disclosure use, exhibition, or other means <br> "P"   document published prior to the international filing date but later than the priority date claimed | "T"   later document published after the international filing date or priority date and not in conflict with the application but cited to understand the principle or theory underlying the invention <br><br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other documents , such combination being obvious to a person skilled in the art <br><br> "&"   document member of the same patent family |

| Date of the actual completion of the international search | Date of mailing of the international search report |
|---|---|
| 22 December 2009    (22.12.2009) | **(04/01/2010)** |

| Name and mailing address of the ISA/ <br> O.E.P.M. <br><br> Paseo de la Castellana, 75 28071 Madrid, España. <br> Facsimile No.   34 91 3495304 | Authorized officer <br><br> J. Botella Maldonado <br><br> Telephone No. +34 91 349 53 82 |

Form PCT/ISA/210 (second sheet) (July 2009)

## INTERNATIONAL SEARCH REPORT

Information on patent family members

| International application No. |
| --- |
| PCT/ ES 2009/000412 |

| Patent document cited in the search report | Publication date | Patent family member(s) | Publication date |
| --- | --- | --- | --- |
| EP 1675217 AB | 28.06.2006 | EP 20050380256<br>US 2006170583 A<br>US 7336215 B<br>ES 2274674 AB<br>AT 374439 T<br>DE 602005002614 T | 22.11.2005<br>03.08.2006<br>26.02.2008<br>16.05.2007<br>15.10.2007<br>26.06.2008 |
| US 2004104835 A | 03.06.2004 | JP 2005079599 A | 24.03.2005<br>24.03.2005<br>24.03.2005 |
| US 4606848 A | 19.08.1986 | NONE | ------------ |
| US 5085931 A | 04.02.1992 | CA 2005198 A<br>EP 0380267 AB<br>EP 19900300632<br>AU 4708889 A<br>JP 2235396 A<br>AU 615817 B<br>DE 69004109 T | 26.07.1990<br>01.08.1990<br>22.01.1990<br>02.08.1990<br>18.09.1990<br>10.10.1991<br>11.05.1994<br>11.05.1994 |

Form PCT/ISA/210 (patent family annex) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2599944 A
- US 3938152 A
- US 11315645 B
- US 4173018 A
- US 2918671 A
- US 2954552 A
- US 4034375 A
- US 4606848 A

**Non-patent literature cited in the description**

- **W. Donald et al.** The Preparation, Properties and Applications of Some Glass Coated Metal Filaments Prepared by the Taylor-Wire Process. *Journal of Material Science,* 1996, vol. 31, 1139-1148
- **H. Wiesner ; J. Schneider.** Magnetic Properties of Amorphous Fe_P Alloys Containing Ga, Ge and As. *Stat. Sol.,* 1974, vol. 26, 71
- *Phys. Stat. Sol. (a),* 1974, vol. 26, 71